# EUROPEAN PATENT APPLICATION

(11) **EP 4 546 050 A1**
(43) Date of publication of application: **30.04.2025**
(21) Application number: 23205083.1
(22) Date of filing: 23.10.2023
(51) Int. Cl.: G03F 7/039, G03F 7/095, G03F 7/20, G03F 7/40, H01L 29/16, H01L 29/786, B82Y 10/00

(54) **METHOD FOR PATTERNING GRAPHENE LAYERS THROUGH PHOTOLITHOGRAPHY FOR A SCALABLE FABRICATION OF GRAPHENE DEVICES**

(71) Applicant: Valstybinis Moksliniu Tyrimu Institutas Fiziniu Ir Technologijos Mokslu Centras, 02300 Vilnius (LT)
(72) Inventor: Alexeeva, Natalia, Vilnius (LT); Jorudas, Justinas, Vilnius (LT); Kasalynas, Irmantas, Vilnius (LT)
(74) Representative: Pakeniene, Ausra

(57) **Abstract**

The process flow of graphene patterning for a scalable fabrication of graphene devices is described in which a graphene layer avoids direct contact with the photoresist and its residuals during all fabrication steps. The proposed method utilizes the specific properties of UV-sensitive photoresists, that can also demonstrate DUV-sensitivity, and DUV-sensitive properties of PMMA, based on the fact that chemical processes occurring in the resist films under exposure to suitable wavelengths result in an increased solubility in the developer, whereby a structured mask of the resists can be produced.

## Description

### Field of the invention

The invention relates to the field of patterning of graphene layers on a substrate through photolithography for a scalable fabrication of graphene devices in such a way that the graphene avoids direct contact with photoresist or its residues during the processing steps.

### Background of the invention

Graphene has attracted attention since its unique physical properties were experimentally validated, triggering the research and development of graphene devices for various applications. Among the methods of synthesizing graphene, chemical vapor deposition (CVD) is considered as the most promising way for a scalable fabrication of graphene devices. For the practical application of CVD graphene in electronics, the challenges in graphene patterning, such as excellent quality, consistency, and scalability, must be addressed for device integration. For a small volume patterning of the graphene, an electron beam lithography (EBL) is employed by using a resist which contains polymethyl methacrylate (PMMA) as a base resin sensitive to an exposure of the electron beam. However, this method requires complex equipment and extensive fabrication time as single device is patterned in each round, therefore it is not suitable for mass production of large number of graphene devices.

PMMA is a well-known photoresist for nano-lithography with the exposure systems using short UV wavelengths (<260 nm) for scission of electron-sensitive polymer chains. Exposure dose results in shorter PMMA fragments in the exposed area for easier dissolution and removal. A focused electron beam is used for this purpose as an maskless exposure system in the EBL, technology of which is used in low-volume (small-scale) production of semiconductor devices. However, an exposure system based on electromagnetic DUV radiation source (example is low-pressure mercury vapour ultraviolet lamps) can simultaneously expose the entire area of the resist, as it happens in photolithography.

Chinese Patent application, publication No.: CN104317162A discloses a chemical patterning method of graphene layers through traditional ultra-violet (UV) photolithography. The method comprises the following steps: 1) coating a photoresist material on the surface of graphene; 2) carrying out exposure and development on a photoresist material and graphene composite obtained in step 1) to obtain a required pattern; 3) feeding the photoresist material and graphene composite exposed and developed in step 2) into a reactor, and converting the developed and exposed graphene into graphite; 4) removing the photo-resistant material off the composite obtained in step 3) to obtain patterned graphene. Due to use of photoresist material on the surface of graphene, the photosensitizer inhibits the novolac resin from dissolving, but when irradiated with the UV light, the photosensitizer converts into indene carboxylic acid to be hydrophilic, which causes the novolac resin to decompose and dissolve in a developing solution, so that patterning can be done. However, the novolac resin and the photosensitizer each contain a benzene ring and thus are readily π- π stacked with graphene. Accordingly, if the photoresist based on novolac resin is used in fabrication processes, the resist and its products cannot be completely removed. It contaminates the graphene, causing a problem of degrading the performance of the graphene devices.

European patent application, publication No.: EP3460573A1, and Japanese Patent No.: JP6971896B2, discloses a photosensitive composition that can suppress contamination and performance deterioration of the graphene. Due to its photochemical properties this photosensitive composition as a resist prevents from being π-π stacked with the graphene, making it possible to reduce the contamination and performance degradation of the graphene. Disadvantage of this method is that the photoresist, designed as a specific photosensitive composition with unique photochemical properties still comes into direct contact with graphene during processing.

An international patent application, publication No.: WO2017218833A1, discloses method of patterning graphene with a hard mask coating for enhanced photolithography with gold (Au) or aluminium (Al) film insertion for large-scale patterning of CVD graphene. A hard mask metal layer composed of any inert metal film like for example Au or Al was evaporated onto the surface of graphene, and then UV photolithography with common UV photoresist followed by wet etching were used to pattern the graphene. After Ar plasma treatment and removal of the Au/AI mask, patterned graphene was obtained. Usage of hard masks as a barrier between photoresist and graphene allows to avoid any contact between them. The graphene sample with the photoresist layer is rinsed in acetone followed by isopropanol alcohol, which effectively dissolve the photoresist layer. Disadvantage of the method is that the photoresist and its residuals get in contact with graphene during the removal step of the photoresist in wet solvent. Moreover, extra technological steps such as metal film deposition and its subsequent removal are needed.

### Brief description of the invention

The invention is method for patterning graphene layers through photolithography for scalable fabrication of graphene devices. The method comprises employing a photoresist and an intermediate PMMA layer to prevent contact with graphene during processing steps. The photoresist is used to form a mask for PMMA layer therefore selected photoresist must absorb light efficiently in DUV spectrum range. Complete removal of the photoresist is done prior to development of exposed portions of PMMA layer. Upon patterning of the graphene, the PMMA mask from graphene surface is removed in alcohol/water mixture. The method further comprises use of the PMMA layer as a supportive layer in wet transfer process of CVD graphene. The graphene avoids direct contact with the photoresist or its residues. PMMA utilization as a double purpose layer reduces fabrication cost and time of the graphene devices.

Commercially available photoresists and developers can be used in this method. A low-pressure mercury vapor lamps can be used as a source of UV-C spectrum, such lamps are inexpensive, easy to maintain, and can be used to expose large areas. The method according to the invention allows to produce large number and low-cost graphene devices by means of photolithography, widely used in industry of semiconductors.

### Brief description of drawings

Features of the invention believed to be novel and inventive are set forth with particularity in the appended claims. The invention itself, however, may be best understood by reference to the following detailed description of the invention, which describes exemplary embodiments, given in non-restrictive examples, of the invention, taken in conjunction with the accompanying drawings, in which:
Fig. 1 shows initial structure of a sample comprising a PMMA layer, a graphene layer and a substrate.
Fig. 2 shows structure comprising the PMMA layer, the graphene layer, the substrate and a photoresist layer as top layer.
Fig. 3 shows photoresist/PMMA/graphene/substrate subjected to UV light at 365 nm through the photomask.
Fig. 4 shows the structure comprising the PMMA layer, the graphene layer, the substrate and the photoresist layer with exposed area of photoresist layer after UV exposure.
Fig. 5 shows structure comprising the PMMA layer, the graphene layer, the substrate and the photoresist layer after development of parts of exposed photoresist, resulting in formation of a photoresist mask.
Fig. 6 shows structure comprising the PMMA layer, the graphene layer, the substrate and the photoresist mask subjected to DUV light at 254 nm through the photoresist mask.
Fig. 7 shows structure comprising the PMMA layer, the graphene layer, the substrate and the photoresist mask after DUV exposure.
Fig. 8 shows structure comprising the PMMA layer, the graphene layer and the substrate when the photoresist mask is developed and removed .
Fig. 9 shows structure comprising the PMMA layer, the graphene layer and the substrate after exposed PMMA layer is subjected to developer comprising alcohol and water resulting in a PMMA mask formation.
Fig. 10 shows structure comprising the PMMA mask, the graphene layer and the substrate where uncovered graphene is etched with RIE (reactive ion etching) through the PMMA mask.
Fig. 11 shows structure comprising the PMMA mask, patterned graphene layer and the substrate after etched graphene has been removed (resulting in GrO formation instead).
Fig.12 shows patterned structure comprising patterned graphene and substrate after a PMMA mask is exposed to DUV at 254 nm, developed in solution of alcohol and water, and removed.
Fig.13 shows dielectric layer deposition onto structure comprising the patterned graphene and substrate layer.
Fig. 14 shows an optical image of patterns of on high resistivity silicon substrate.

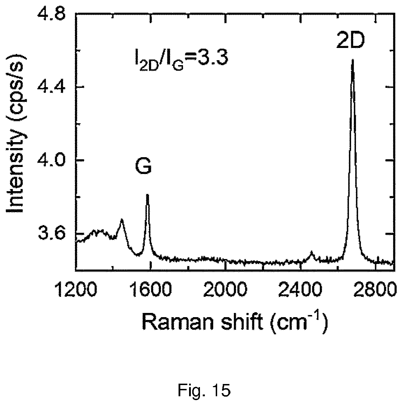

Fig. 15 shows the Raman spectrum of graphene device patterned according to the invention.

Measurements were performed using a Raman spectrometer using a green laser (λ = 532 nm) and a grating of 1800 lines/mm. The observed spectrum was measured using 5% power, integration time T = 100 s, at the main line v0 = 2050 cm⁻¹. Observed lines are typical for spectrum of the mono-layer graphene.

### Detailed description of the invention

It should be understood that numerous specific details are presented in order to provide a complete and comprehensible description of the invention embodiment. However, the person skilled in art will understand that the embodiment examples do not limit the application of the invention which can be implemented without these specific instructions. Well-known methods, procedures and components have not been described in detail for the embodiment to avoid misleading. Furthermore, this description should not be considered to be constraining the invention to given embodiment examples but only as one of possible implementations of the invention.

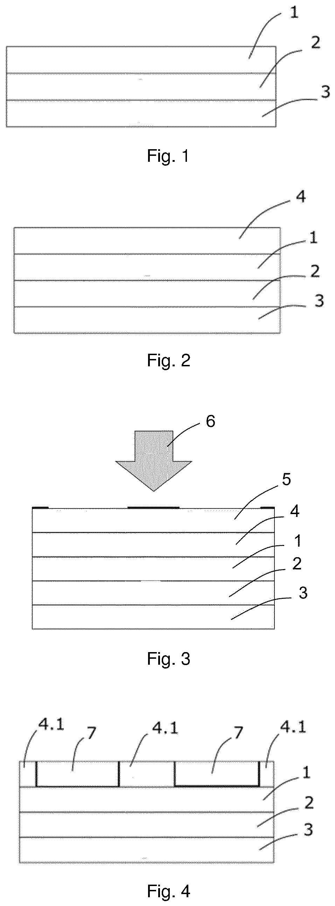

The method for patterning of graphene layers through photolithography for a scalable fabrication of graphene devices comprises transferring a graphene layer (2) on to a substrate (3). The graphene layer (2) is followed by a PMMA layer (1) as shown in Fig. 1. Structure comprising the PMMA layer (1), the graphene layer (2) and the substrate (3) may be the result of, for example, the wet transfer of graphene from a Cu foil on which graphene is grown, or structuring in the manufacture of graphene devices when PMMA is used as a mask layer. The PMMA resin layer is coated on graphene surface using any procedures known in the field for coating graphene surface with PMMA resin. The substrate may be selected from materials such as silicon, silicon dioxide, sapphire, or silicon carbide. According to one example, a layer of commercial CVD graphene (2) is coated with a 60 nm thick 495 K molecular weight PMMA layer (1) used as a supportive layer for graphene transfer from Cu foil to the substrate of choice. According to another example the PMMA layer (1) can have thickness of 950 K molecular weight PMMA, in particular specifically ~250 nm, for structuring in the manufacture of graphene devices. Subsequently, and as shown in Fig. 2 structure comprising the PMMA layer (1), the graphene layer (2) and the substrate (3) is spin-coated with a photoresist layer (4), such as AZ MiR 701 29cPs or AZ6612, at 4000 rpm for 30 s, resulting in ~1.4-1.6 µm thickness of the photoresist layer (4) and prebaked for 60 s at 90 °C. The photoresist layer (4) is such that absorb light at a wavelength of 365 nm and at 254 nm. The 365 nm UV range is a range in which photoresists are normally designed to work and the 254 nm represents deep UV range (DUV).

Conventional photoresist is a resist, that is designed for photolithography with the exposure systems using specific UV wavelengths (320-450 nm, usually i-line of 365 nm wavelength is employed), either breaks down or hardens where it is exposed to light through a photomask. A photoresist mask is formed by transferring scale geometric design of a photomask to a light-sensitive chemical (photoresist) on the substrate of choice. The novelty is that the photoresist used in the invention is characterised by absorbing at a wavelength of 254 nm in addition to 365 nm. A few commercially available photoresists are found to absorb also at DUV wavelengths. Ultimately, the use of a second absorption line allows the photoresist to not come into direct contact with the graphene surface at any of the stage of processing, thus avoiding graphene contamination and residuals' introduction to the surface of graphene.

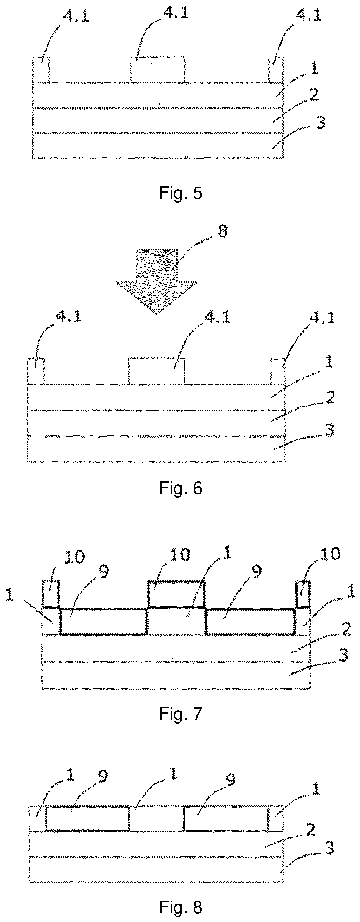

Afterwards, as shown in Fig. 3, structure comprising the photoresist layer (4), the PMMA layer (1), the graphene layer (2) and the substrate (3) is subjected to UV light (6) at 365 nm through a photomask (5) to expose the photoresist layer (4) fully. Areas (7) of the exposed photoresist layer (4), as shown in Fig. 4, are affected, resulting in formation of shorter chains in polymer that dissolve significantly faster compared to long chains of the polymer. The exposed photoresist layer (4) areas (7) are removed by baking for 50-60 s at 110°C the structure comprising the PMMA layer (1), the graphene layer (2), the substrate (3) and the photoresist layer (4) and developing in AZ726 MIF for 30 s. A photoresist mask (4.1) is formed on the top of structure comprising the PMMA layer (1), the graphene layer (2) and the substrate (3), as shown in Fig. 5.

Afterwards, as shown in Fig. 6, the PMMA layer (1) is subjected to DUV radiation (8) through the photoresist mask (4.1), which in turn also absorbs DUV, for two hours for 60 nm thick PMMA layer, until both the PMMA layer (1) and the photoresist mask (4.1) are exposed. For a PMMA layer (1) with a thickness of about 250 nm, exposure time increases up to ~ 6 hours. The PMMA layer (1) and the photoresist layer are exposed using a non-collimated DUV radiation source, such as Crosslinker XL-1000, equipped with low pressure mercury vapour ultraviolet lamps, such as Philips T5 Germicidal UV-C, which radiation is in the range from 100 nm to 280 nm with the strongest peak in the emission spectrum at 254 nm.

Figure 7 illustrates that the exposure dose induces scission in exposed area (9) of the PMMA layer (1) and exposed area (10) of the photoresist mask (4.1) leading to formation of short chains in both polymers that dissolve significantly faster compared to long chains in the polymer. As both the photoresist mask (4.1) used and the PMMA layer (1) can absorb light at 254 nm, an exposed areas (10) of the photoresist mask (4.1) and an exposed areas (9) of the PMMA layer (1) are formed simultaneously under DUV exposure. Besides scission of polymer chain the polarity of PMMA layer during DUV exposure is increased [Justinas Jorudas et al. "Green Removal of DUV-Polarity-Modified PMMA for Wet Transfer of CVD Graphene" NANOMATERIALS, vol. 12, issue 22, 15 November 2022] and dissolution of exposed PMMA in a developer occurs faster releasing clean graphene surface.

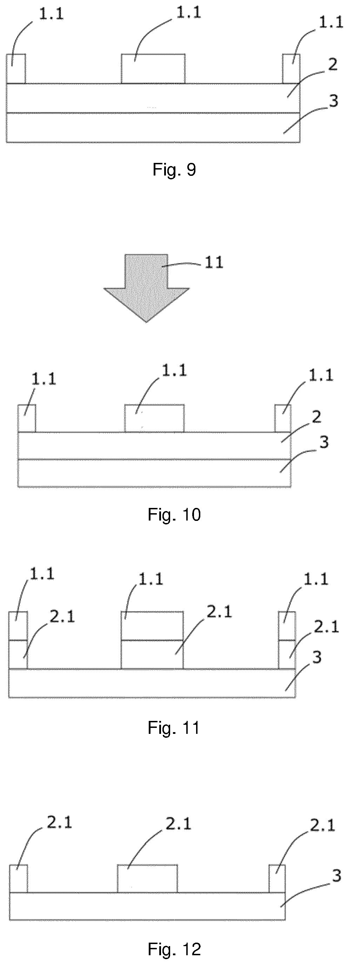

The photoresist (10) is further developed in AZ726 MIF for 30 sec after the exposure to DUV and removed first. The PMMA layer (1, 9) still completely covers the entire sample comprising the graphene layer (2) and the substrate (3) so that the photoresist mask (4.1) is removed without touching surface of the graphene layer (2). A PMMA mask (1.1) is formed as shown in Fig. 9 on the layered sample comprising the graphene layer (2) and the substrate (3) after development of the exposed PMMA areas (9) in mixture of alcohol and water for 30 seconds and then drying by a stream of nitrogen gas. Accordingly, development of 250 nm thick PMMA (9) takes about 60 seconds. To develop the exposed portions of PMMA layer (9) a mixture of alcohol and water IPA: H₂O volumetric ratio 7-to-3, is used both utilizing its excellent properties as a developer with enhanced dissolution rate and avoiding residuals on the surface of graphene.

Figure 11 shows a patterned graphene layer (2.1) on the target substrate (3) under the PMMA mask (1.1) as a result of etching of uncovered graphene with oxygen plasma (11) as shown in Fig. 10. Method of etching graphene sample through the PMMA mask (1.1) in Oxygen asher (100W RF power, ~15 sccm O₂, 0.5 mTorr) was tested. The DUV exposed PMMA mask (9) is removed in a non-toxic mixture of alcohol and water obtaining a patterned graphene layer (2.1).

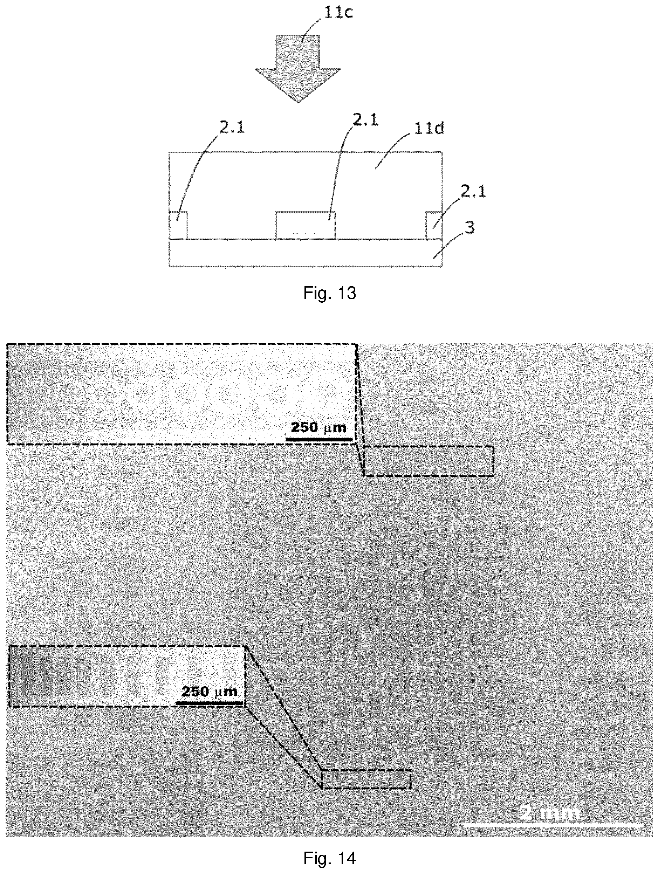

If, according to the manufacturing technology of a device, isolation of necessary areas is required, dielectric layer (11d) coating of the whole layered sample comprising the patterned graphene layer (2.1) and the substrate (3) takes place after subjected to deposition (11c) of a dielectric layer for isolation between patterned graphene samples, as shown in Fig. 13 including electric contacts and wires, which are not shown.

## Claims

1. Method for patterning a graphene layer through photolithography for a scalable fabrication of graphene devices, the method comprising providing a structure comprising of a PMMA layer (1), a graphene layer (2) and a substrate (3), coating the structure comprising of the PMMA layer (1), the graphene layer (2) and the substrate (3) with a photoresist layer (4), forming a photoresist mask (4.1) through photolithography steps using UV irradiation of 365 nm, subjecting the PMMA layer (1) and the photoresist mask (4.1) to irradiation, dissolving the photoresist mask (4.1) **characterized in that**
the photoresist mask (4.1) is formed of a selected photoresist (4) which has specific absorption property at 254 nm wavelength of DUV irradiation and at 365 nm wavelength of UV irradiation,
the PMMA layer (1) and the photoresist mask (4.1) are subjected to DUV irradiation of 254 nm wavelength to form areas of an exposed photoresist (10) and an exposed PMMA (9),
the exposed photoresist (10) is developed and removed first, keeping the graphene layer (2) completely covered with PMMA layer (1, 9)
the exposed PMMA (9) is developed in the mixture of alcohol and water to form a PMMA mask (1.1) on the surface of graphene layer (2).

2. Method according to claim 1, **characterized in that** whole graphene layer (2) coated with PMMA layer (1) and photoresist (4) forming the mask (4.1) is exposed to DUV for 2-6 hours, depending on the PMMA layer thickness, with a low-pressure mercury vapour lamp with an emission spectrum in the range of 100-280 nm, with a peak at 253.7 nm.

3. Method according to claim 1 or 2, **characterized in that** after removal of the exposed photoresist (10) the exposed PMMA (9) is developed in the alcohol/water mixture selected from a group consisting of the following mixtures: methanol/water, ethanol/water, isopropanol/water.

4. Method according to claim 3, **characterized in that** the exposed PMMA (9) is developed in the isopropanol/water mixture having an isopropanol/water volumetric ratio in the range of 70:30 to 75:25.

5. Method according to claims 1-4, **characterized in that** oxygen plasma etches unprotected graphene through the PMMA mask (1.1) in order to pattern a graphene layer (2.1);

6. Method according to claims 1-5, **characterized in that** after patterning of graphene, the PMMA mask (1.1) is removed by exposing to DUV and developing in mixture of isopropanol/water.

7. Method according to claims 1-6, **characterized in that** dielectric layer can be deposited on the whole sample with patterned graphene providing isolation between selected areas of the patterned graphene (2.1) as a further technology step.
